# EUROPEAN PATENT APPLICATION

(11) **EP 4 455 849 A1**
(43) Date of publication of application: **30.10.2024**
(21) Application number: 24161125.0
(22) Date of filing: 04.03.2024
(51) Int. Cl.: G06F 3/041, G06F 3/044, H10K 59/131, H10K 59/40

(54) **DISPLAY DEVICE**

(30) Priority: 26.04.2023 KR 20230054873
(71) Applicant: Samsung Display Co., Ltd., Yongin-si, Gyeonggi-do 17113 (KR)
(72) Inventor: Choi, Chaun Gi, Giheung-gu, Yongin-si, Gyeonggi-do (KR); KIM, Dong Uk, Giheung-gu, Yongin-si, Gyeonggi-do (KR); KIM, Hyun Ho, Giheung-gu, Yongin-si, Gyeonggi-do (KR); KIM, Hyoeng Ki, Giheung-gu, Yongin-si, Gyeonggi-do (KR)
(74) Representative: Dr. Weitzel & Partner

(57) **Abstract**

A display device includes a display panel including a display area including light-emitting elements and a non-display area including display pads and touch pads. The display panel may include touch electrodes disposed on the light-emitting elements in the display area, touch lines electrically connected to the touch electrodes and extended to the non-display area, and a switching circuit electrically connected to the touch lines through input pads in the non-display area and switching connections between the touch lines and touch connection lines electrically connected to the touch pads. The input pads are disposed in a contact area of the non-display area. The contact area of the non-display area is an area on which inorganic films are stacked.

## Description

### BACKGROUND

### 1. Technical Field

The present invention relates to a display device.

### 2. Description of the Related Art

Display devices may be flat panel display devices such as a liquid-crystal display device, a field emission display device, and an organic light-emitting display device. A display device may include a touch sensing device (for example, a touch sensor) that recognizes a touch input as an input device. The touch sensing device may determine whether there is a user's touch input by capacitive sensing and identify the position where the touch input is sensed (for example, touch input coordinates).

Touch sensing devices may be operated by capacitive sensing, resistive sensing, or sensing using infrared ray, sound waves or pressure. Among these, the capacitive sensing is most commonly used. A capacitive touch screen may include touch electrodes and detects if there is a touch based on a change in capacitance. Such a capacitive touch screen has good touch sensitivity, and thus is employed in most small and medium-sized display devices.

The capacitance sensing may be sorted into mutual-capacitance sensing using touch electrodes intersecting one another with a dielectric layer therebetween, and self-capacitance sensing using individually disposed touch electrodes in a single layer. Recently, in 10-inch or larger display devices, RC load may be increased and thus the performance of touch sensors may be deteriorated. To prevent this, a display device employing self-capacitance sensing is being developed.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Aspects of the invention provide a large-screen display device that can prevent performance of touch sensors from being deteriorated due to an increase in RC load (load due to resistance and capacitance components) and can reduce the area of the dead space, which is a non-display area. The invention is defined by the features of claim 1. The dependent claims describe preferred embodiments.

According to the present invention, a display device includes a display panel including a display area including light-emitting elements and a non-display area including display pads and touch pads. The display panel includes a plurality of touch electrodes disposed on the light-emitting elements in the display area; a plurality of touch lines electrically connected to the plurality of touch electrodes and extended to the non-display area; and a switching circuit electrically connected to the plurality of touch lines through a plurality of input pads in the non-display area and switching a connection, that is an electrical connection, between the plurality of touch lines and touch connection lines electrically connected to the touch pads. The plurality of input pads is disposed in a contact area of the non-display area. The contact area of the non-display area is an area on which a plurality of inorganic films are stacked. That is, the plurality of inorganic films are immediately in the area in which the input pads are disposed.

The contact area may be free of any organic film.

Each of the plurality of input pads may comprise a pad electrode stacked on a layer among the inorganic films and electrically connected to a thin-film transistor of the switching circuit, and a pad contact hole penetrating at least a part or a number of the inorganic films to expose an upper surface of the pad electrode. Each of the plurality of touch lines may be extended from the display area to the contact area and is connected to the pad electrode through the pad contact hole.

The display device may further comprise in the display area, a first thin-film transistor including a first gate electrode and a first inorganic layer disposed on the first gate electrode; a second thin-film transistor disposed on the first thin-film transistor and including a second gate electrode and a second inorganic film disposed on the second gate electrode; an OLED disposed on the second thin-film transistor and including an emissive layer, and at least one organic film disposed between the second thin-film transistor and the OLED.

The plurality of touch electrodes may be disposed in a layer on the OLED, and the plurality of touch lines and the plurality of touch electrodes may be disposed in a same layer.

The pad electrode and the second gate electrode of the second thin-film transistor may be disposed in a same layer.

The pad contact hole may penetrate the second inorganic film to expose the upper surface of the pad electrode.

The switching circuit may comprise a plurality of switching thin-film transistors that switch connections between the plurality of touch lines and the touch connection lines at a ratio of n : 1 where n is an integer equal to or greater than two.

The plurality of switching thin-film transistors and one of the first thin-film transistor and the second thin-film transistor may be disposed in a same layer.

A passivation film and the at least one organic film disposed between the second thin-film transistor and the OLED disposed in a same layer may be disposed on one of a switching thin-film transistor of the plurality of switching thin-film transistors.

A capacitor electrode disposed on a layer between the first thin-film transistor and the second thin-film transistor may be disposed in the display area. The capacitor electrode, the first gate electrode, and the second gate electrode may be formed of a same material.

According to an embodiment, a display device includes a display panel including a display area including light-emitting elements and a non-display area including display pads and touch pads. The display panel includes a plurality of touch electrodes disposed on the light-emitting elements in the display area; a plurality of touch lines electrically connected to the plurality of touch electrodes and extended to the non-display area, and a switching circuit electrically connected to the plurality of touch lines through a plurality of input pads in the non-display area and switching a connection, that is an electrical connection, between the plurality of touch lines and touch connection lines electrically connected to the touch pads. The plurality of input pads is disposed in a contact area of the non-display area. The contact area of the non-display area is an area on which a plurality of inorganic films are stacked. That is, the plurality of inorganic films are immediately in the area in which the input pads are disposed. The contact area is disposed between a border of the non-display area disposed on an outer side of the switching circuit.

The contact area may be free of any organic film.

Each of the plurality of input pads may include a pad electrode stacked on a layer among the inorganic films and electrically connected to the switching circuit, and a pad contact hole penetrating at least a part of the inorganic films to expose an upper surface of the pad electrode. Each of the plurality of touch lines may be extended from the display area to the contact area via the switching circuit and is electrically connected to the pad electrode through the pad contact hole.

The display device may further comprise in the display area, a first thin-film transistor including a first gate electrode and a first inorganic layer disposed on the first gate electrode; a second thin-film transistor disposed on the first thin-film transistor and including a second gate electrode and a second inorganic film disposed on the second gate electrode; an OLED disposed on the second thin-film transistor and including an emissive layer, and at least one organic film disposed between the second thin-film transistor and the OLED.

The plurality of touch electrodes may be disposed in a layer on the OLED, and the plurality of touch lines and the plurality of touch electrodes may be disposed in a same layer.

The pad electrode and the second gate electrode of the second thin-film transistor may be disposed in a same layer.

The pad contact hole may penetrate the second inorganic film to expose the upper surface of the pad electrode.

The switching circuit may comprise a plurality of switching thin-film transistors that switch connections between the plurality of touch lines and the touch connection lines at a ratio of n : 1 where n is an integer equal to or greater than two.

The plurality of switching thin-film transistors and one of the first thin-film transistor and the second thin-film transistor may be disposed in a same layer.

A passivation film and the at least one organic film disposed between the second thin-film transistor and the OLED may be disposed on one of a switching thin-film transistor of the plurality of switching thin-film transistors.

A capacitor electrode may be disposed on a layer between the first thin-film transistor and the second thin-film transistor disposed in the display area. The capacitor electrode, the first gate electrode, and the second gate electrode may be formed of a same material.

According to embodiments, it is possible to prevent performance of touch sensors from being deteriorated due to an increase in RC load (load due to resistance and capacitance components) in a display device and to reduce the area of the dead space, which is a non-display area.

However, aspects are not restricted to those set forth herein. The above and other aspects will become more apparent to one of ordinary skill in the art to which the invention pertains by referencing the detailed description given below.

### BRIEF DESCRIPTION OF THE DRAWINGS

The above and other aspects and features will become more apparent by describing in detail embodiments thereof with reference to the attached drawings, in which:
FIGS. 1 and 2 are schematic perspective views showing a display device according to an embodiment.
FIG. 3 is a schematic plan view showing the second state of the display device according to an embodiment.
FIG. 4 is a schematic plan view a non-display area near a switching circuit according to an embodiment.
FIG. 5 is a schematic cross-sectional view showing a cross section of a display area of a display panel according to an embodiment.
FIG. 6 is a schematic cross-sectional view showing an example of the display panel taken along line B - B' of FIG. 4.
FIG. 7 is a schematic circuit diagram showing an example of a switching circuit according to an embodiment.
FIG. 8 is a schematic plan view showing input pads connected to switching circuits according to an embodiment.
FIG. 9 is a schematic cross-sectional view showing an example of the display panel, taken along line C - C' of FIG. 8.
FIG. 10 is a schematic perspective view of a display device according to an embodiment.
FIG. 11 is a schematic cross-sectional view of the display device shown in FIG. 10.
FIG. 12 is a block diagram for illustrating driving a display unit and a touch unit according to an embodiment.
FIG. 13 is a schematic plan view showing a display panel according to an embodiment.

### DETAILED DESCRIPTION OF THE EMBODIMENTS

The invention will now be described more fully hereinafter with reference to the accompanying drawings, in which embodiments are shown. This invention may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will also be understood that when a layer is referred to as being "on" another layer or substrate, it can be directly on the other layer or substrate, or intervening layers may also be present. The same reference numbers indicate the same components throughout the specification.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

Features of each of various embodiments may be partially or entirely combined with each other, and respective embodiments may be implemented independently of each other or may be implemented together in association with each other.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

The terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments may be described and illustrated in the accompanying drawings in terms of functional blocks, units, and/or modules.

Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies.

In the case of the blocks, units, and/or modules being implemented by microprocessors or other similar hardware, they may be programmed and controlled using software (for example, microcode) to perform various functions discussed herein and may optionally be driven by firmware and/or software.

It is also contemplated that each block, unit, and/or module may be implemented by dedicated hardware, or as a combination of dedicated hardware to perform some functions and a processor (for example, one or more programmed microprocessors and associated circuitry) to perform other functions.

Each block, unit, and/or module of embodiments may be physically separated into two or more interacting and discrete blocks, units, and/or modules without departing from the scope of the invention.

Further, the blocks, units, and/or modules of embodiments may be physically combined into more complex blocks, units, and/or modules without departing from the scope of the invention.

Hereinafter, embodiments will be described with reference to the accompanying drawings.

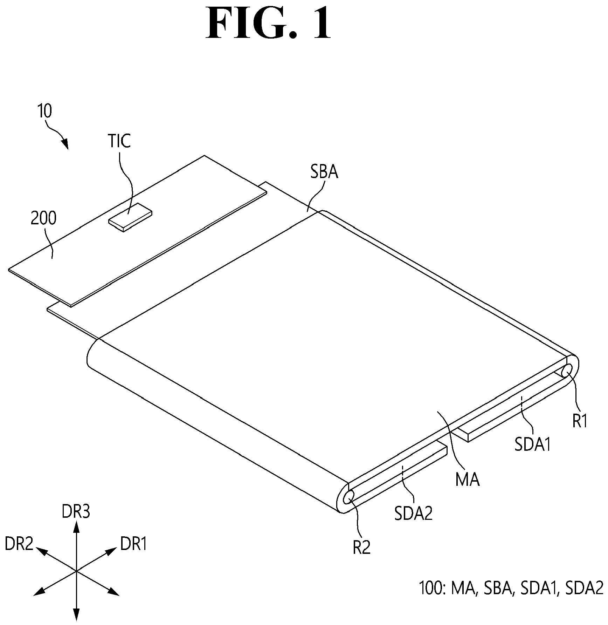

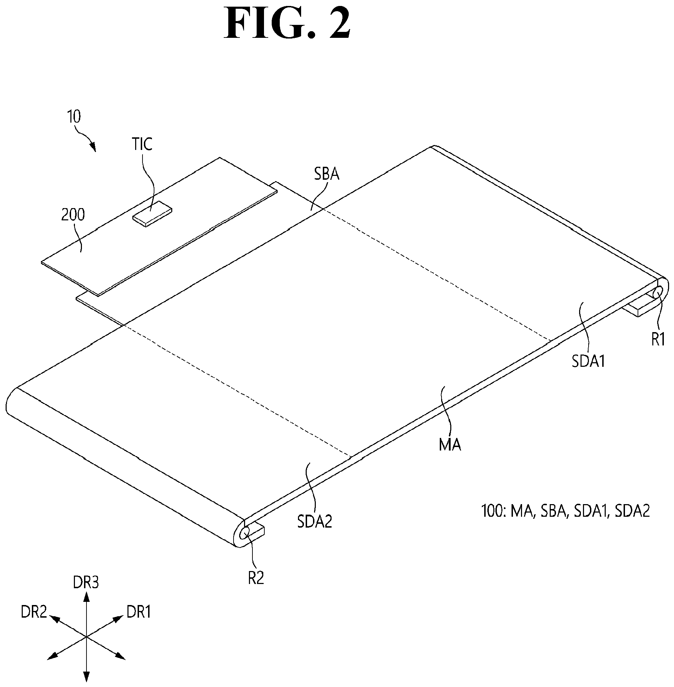

FIGS. 1 and 2 are schematic perspective views showing a display device according to an embodiment. FIG. 1 is a schematic perspective view showing a first state of a display device. FIG. 2 is a schematic perspective view showing a second state of a display device.

Referring to FIGS. 1 and 2, a display device 10 may be employed by portable electronic devices such as a mobile phone, a smart phone, a tablet PC, a mobile communications terminal, an electronic notebook, an electronic book, a portable multimedia player (PMP), a navigation device and an ultra-mobile PC (UMPC). As an example, the display device 10 may be used as a display unit of a television, a laptop computer, a monitor, an electronic billboard, or the Internet of Things (IOT). As an example, the display device 10 may be applied to wearable devices such as a smart watch, a watch phone, a glasses-type display, and a head-mounted display (HMD) device.

The display device 10 may be a light-emitting display device such as an organic light-emitting display device using organic light-emitting diodes, an inorganic light-emitting display device including an inorganic semiconductor, and a micro light-emitting display device using micro or nano light-emitting diodes (micro LEDs or nano LEDs). In the following description, an organic light-emitting display device is described as an example of the display device 10. It is, however, to be understood that the invention is not limited thereto.

The display device 10 may include a display panel 100, a circuit board 200, a first roller R1 and a second roller R2.

The display panel 100 may be a flexible display panel 100 that can be folded, curved, or bent by the first roller R1 and the second roller R2. Such a display panel 100 may be referred to as a slidable display panel, a rollable display panel, a bendable display panel, a stretchable display panel, etc.

The display panel 100 may include a main area MA, a subsidiary area SBA, a first auxiliary area SDA1, and a second auxiliary area SDA2.

In case that substantially only the main area MA can be seen from the front of the display device 10 and the first auxiliary area SDA1 and the second auxiliary area SDA2 are not visible, this may be defined as a first state of the display device 10. The first state may be referred to as a slide-out state or a maximum reduction state.

In case that substantially the entirety of the first auxiliary area SDA1 and the second auxiliary area SDA2 can be seen from the front of the display device 10 as well as the main area MA, this may be defined as a second state of the display device 10. The second state may be referred to as a slide-out state or a maximum expansion state.

The display device 10 may have a third state, which is between the first state and the second state. For example, the third state may be referred to as a transition state or third shape. The third state may include a free stop state.

In FIGS. 1 and 2, a first direction DR1 indicates the horizontal direction of the display panel 100, a second direction DR2 indicates the vertical direction of the display panel 100, and a third direction DR3 indicates the thickness direction of the display panel 100. As used herein, the terms "left," "right," "upper" and "lower" sides indicate relative positions when the display panel 100 is viewed from the top. For example, the right side refers to one side or a side in the first direction DR1, the left side refers to the other side in the first direction DR1, the upper side refers to one side in the second direction DR2, and the lower side refers to the other side in the second direction DR2. The upper portion refers to the side indicated by the arrow of the third direction DR3, while the lower portion refers to the opposite side in the third direction DR3.

The main area MA may be, but is not limited to, a flat area that is not folded, curved, or bent. The main area MA may have, but is not limited to, a rectangular shape when viewed from the top. The length of the main area MA in the first direction DR1 may be greater than the length in the second direction DR2.

The subsidiary area SBA may be located (or disposed) on one side or a side of the main area MA in the second direction DR2. In other words, the subsidiary area SBA may be extended the main area MA in the second direction DR2. The subsidiary area SBA may be a folded, curved or bent. In case that the subsidiary area SBA is bent, the subsidiary area SBA may overlap the main area MA in the third direction DR3. The subsidiary area SBA may have, but is not limited to, a rectangular shape when viewed from the top.

The length of the subsidiary area SBA in the first direction DR1 may be substantially equal to the length of the main area MA in the first direction DR1. As an example, the length of the subsidiary area SBA in the first direction DR1 may be smaller than the length of the main area MA in the first direction DR1. The length of the subsidiary area SBA in the second direction DR2 may be smaller than the length of the main area MA in the second direction DR2.

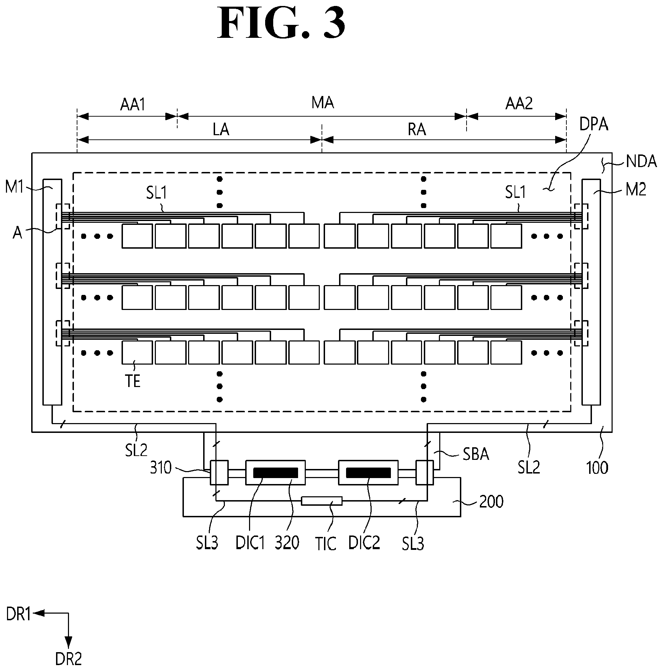

The subsidiary area SBA may include pad area (not shown) connected to the circuit board 200. The pad area may include a touch pad area to which signal lines associated with touch sensors are connected. As will be described later, the signal lines associated with the touch sensor may include touch connection lines SL2 connected to switching circuits M1 and M2 (see FIG. 3). The touch pad area located at a portion of the subsidiary area SBA may include touch pads connected to the circuit board 200. A touch driver circuit TIC may be directly mounted on the touch pads. For example, the touch driver circuit may be implemented as an integrated circuit (IC) and may be mounted on the touch pad area by the chip-on-glass (COG) technique, or the chip-on-plastic (COP) technique. As an example, as shown in FIG. 1, the touch driver circuit TIC may be attached to the circuit board 200.

The circuit board 200 may be attached on the pad area of the display panel 100 using an anisotropic conductive film (ACF). The circuit board 200 may be electrically connected to the pad area of the display panel 100. The circuit board 200 may be a flexible printed circuit board (FPCB), a printed circuit board (PCB), or a flexible film such as a chip-on-film (COF).

Each of the first roller R1 and the second roller R2 may be extended in the second direction DR2. Each of the first roller R1 and the second roller R2 may move in the first direction DR1. Each of the first roller R1 and the second roller R2 has a rotation shaft in the second direction DR2 and may rotate in a first rotation direction or a second rotation direction. The first rotation direction may be clockwise, and the second rotation direction may be counterclockwise. By way of example, each of the first roller R1 and the second roller R2 moves in the first direction DR1 and may rotate in the first rotational direction or the second rotational direction.

A first bending area of the first auxiliary area SDA1 may move in the first direction DR1 with the movement and rotation of the first roller R1. A second bending area of the second auxiliary area SDA2 may move in the first direction DR1 with the movement and rotation of the second roller R2.

In case that the first roller R1 moves to the right and rotates in the second rotation direction, the first bending area of the first auxiliary area SDA1 may move to the left. Accordingly, the first bending area of the first auxiliary area SDA1 may be distant from the main area MA. Therefore, the first auxiliary area SDA1 seen from the front of the display device 10 may be widened.

In case that the second roller R2 moves to the left and rotates in the first rotation direction, the second bending area of the second auxiliary area SDA2 may move to the right. Accordingly, the second bending area of the second auxiliary area SDA2 may be distant from the main area MA. Therefore, the second auxiliary area SDA2 seen from the front of the display device 10 may be widened.

In case that the first roller R1 moves to the right and rotates in the second rotation direction, and the second roller R2 moves to the left and rotates in the first rotation direction, the display device 10 may be switched from the first state to the second state.

On the contrary, in case that the first roller R1 moves to the left and rotates in the first rotation direction, the first bending area of the first auxiliary area SDA1 may move to the right. Accordingly, the first bending area of the first auxiliary area SDA1 may be adjacent to the main area MA. Therefore, the first auxiliary area SDA1 seen from the front of the display device 10 may be narrowed.

In case that the second roller R2 moves to the right and rotates in the second rotation direction, the second bending area of the second auxiliary area SDA2 may move to the left. Accordingly, the second bending area of the second auxiliary area SDA2 may be adjacent to the main area MA. Therefore, the second auxiliary area SDA2 seen from the front of the display device 10 may be narrowed.

In case that the first roller R1 moves to the left and rotates in the first rotation direction, and the second roller R2 moves to the right and rotates in the second rotation direction, the display device 10 may be switched from the second state to the first state.

The first bending area of the first auxiliary area SDA1 in the first state of the display device 10 may be closer to the main area MA than the first bending area of the first auxiliary area SDA1 in the second state of the display device 10 is to. Therefore, in the second state of the display device 10, most of the first auxiliary area SDA1 and the second auxiliary area SDA2 may be seen from the front of the display device 10. In the first state of the display device 10, the first auxiliary area SDA1 and the second auxiliary area SDA2 may hardly be seen from the front of the display device 10. For example, in the first state of the display device 10, the first auxiliary area SDA1 and the second auxiliary area SDA2 may be seen from the right and left edges of the display device 10.

The length of the display panel 100 in the first direction DR1 in the second state of the display device 10 may be greater than the length of the display panel 100 in the first direction DR1 in the first state of the display device 10. In the second state of the display device 10, a portion of the first auxiliary area SDA1 that overlaps the main area MA in the third direction DR3 may be smaller than a portion of the first auxiliary area SDA1 that does not overlap the main area MA in the third direction DR3. On the contrary, in the first state of the display device 10, a portion of the first auxiliary area SDA1 that overlaps the main area MA in the third direction DR3 may be larger than a portion of the first auxiliary area SDA1 that does not overlap the main area MA in the third direction DR3. In the second state of the display device 10, a portion of the second auxiliary area SDA2 that overlaps the main area MA in the third direction DR3 may be smaller than a portion of the second auxiliary area SDA2 that does not overlap the main area MA in the third direction DR3. On the contrary, in the first state of the display device 10, a portion of the second auxiliary area SDA2 that overlaps the main area MA in the third direction DR3 may be larger than a portion of the second auxiliary area SDA2 that does not overlap the main area MA in the third direction DR3.

Since the first auxiliary area SDA1 is folded, bent, or curved with the rotation of the first roller R1, the curvature of the first roller R1 may be substantially equal to the curvature of the first auxiliary area SDA1. Since the second auxiliary area SDA2 is folded, bent, or curved with the rotation of the second roller R2, the curvature of the second roller R2 may be substantially equal to the curvature of the second auxiliary area SDA2. Since the curvature of the first roller R1 may be substantially equal to the curvature of the second roller R2, the curvature of the first auxiliary area SDA1 may be substantially equal to the curvature of the second auxiliary area SDA2. Furthermore, in order to prevent interference with the first and second auxiliary areas SDA1 and SDA2 in case that the subsidiary area SBA is bent, the curvature of the subsidiary area SBA may be different from the curvature of the first auxiliary area SDA1 or the curvature of the second auxiliary area SDA2. For example, the curvature of the subsidiary area SBA may be less than the curvature of the first auxiliary area SDA1 and the curvature of the second auxiliary area SDA2.

As shown in FIGS. 1 and 2, the first auxiliary area SDA1 and the second auxiliary area SDA2 are moved with the movement of the first roller R1 and the second roller R2, and accordingly the size of the display panel 100 visible from the front of the display device 10, for example, the size of the display area DPA where images are displayed may be adjusted. Therefore, the user can select the size of the display panel 100 by adjusting the display device 10 between the first state and the second state depending on the intended use of the display device 10.

FIG. 3 is a schematic plan view showing the second state of the display device according to an embodiment.

Referring to FIG. 3, the display panel 100 of the display device may be divided into a left area LA and a right area RA, and a size of the left area LA and a size of the right area RA may be substantially the same. The display panel 100 of the display device may include a main area MA, a subsidiary area SBA, a first auxiliary area AA1 and a second auxiliary area AA2. FIG. 3 may also include a left area (LA) and a right area (RA). The first auxiliary area AA1 of FIG. 3 is substantially identical to the first auxiliary area SDA1 of FIGS. 1 and 2. The second auxiliary area AA2 of FIG. 3 is substantially identical to the second auxiliary area SDA2 of FIGS. 1 and 2.

The main area MA may include the display area DPA where pixels for displaying images are disposed, and a non-display area NDA around the display area DPA. The non-display area NDA may surround the display area DPA. One side or a side of the non-display area NDA may be adjacent to the subsidiary area SBA. For example, the subsidiary area SBA may be extended from the non-display area NDA located on one side or a side of the display panel 100. The non-display area NDA may be referred to as dead space or bezel.

Touch electrodes TE may overlap the pixels in the display area DPA of the main area MA. For example, the touch electrodes TE may be self-capacitance detection touch electrodes TE.

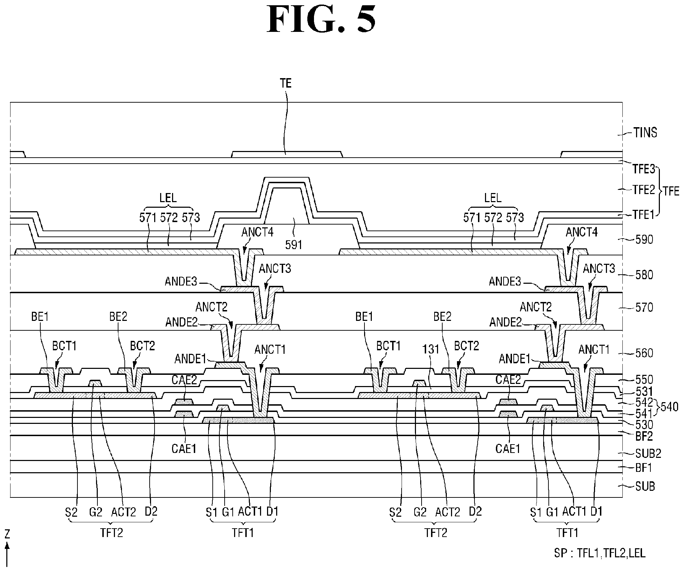

The touch electrodes TE may be located in the display area DPA and arranged (or disposed) in a matrix. For example, the touch electrodes TE may be uniformly arranged over the first auxiliary area SDA1 and the second auxiliary area SDA2 as well as the main area MA of the display panel 100. As will be described later with reference to FIG. 5, the touch electrodes TE may be disposed in a single layer above the light-emitting elements LEL (see FIG. 5) of the pixels.

The touch electrodes TE receive touch driving signals through touch lines SL1. The touch driving signals may be ones output from the touch driver circuit TIC. The touch electrodes TE may be connected to the touch lines SL1, respectively. The touch lines SL1 connected to the touch electrodes TE may be extended to the non-display area NDA and may be connected to the switching circuits M1 and M2 disposed in the non-display area NDA.

The display panel 100 may include one or more switching circuits M1 and M2. For example, the display panel 100 may be designed to have a large area of 10 inches or more, and the number of switching circuits M1 and M2 may increase in proportion to the area of the display panel 100. Although the switching circuits M1 and M2 are disposed on the left and right sides of the display panel 100, respectively, in the example shown in FIG. 3, the invention is not limited thereto. For example, a single switching circuit may be disposed in any one non-display area NDA of the display panel 100. As an example, a single switching circuit may be disposed in the subsidiary area SBA of the display panel 100. As an example, the display panel 100 may include switching circuits M1 and M2, which may be disposed in the subsidiary area SBA. Hereinafter, an example where the switching circuits M1 and M2 are disposed on left and right sides of the display panel 100, respectively, will be described. Herein, the switching circuit may be referred to as a multiplexer MUX.

The switching circuits M1 and M2 are disposed on the left and right sides of the display panel 100, respectively. For example, the first switching circuit M1 may be disposed in the non-display area NDA on one side or a side of the display panel 100, and the first switching circuit M1 may be connected to the touch electrodes TE arranged in the left half of the entire display area DPA through the touch lines SL1. The second switching circuit M2 may be disposed in the non-display area NDA on the opposite side of the display panel 100, and the second switching circuit M2 may be connected to the touch electrodes TE arranged in the right half of the entire display area DPA through the touch lines SL1. The first switching circuit M1 and the second switching circuit M2 may include substantially the same elements and perform the same functions. Therefore, only the features associated with the first switching circuit M1 will be described but the features associated with the second switching circuit M2 will not be described to avoid redundancy.

The first switching circuit M1 may switch the connection between the touch lines SL1 and the touch connection lines SL2 extended from the touch pad area. The touch connection lines SL2 may be connected to the pad area and may transfer touch driving signals output from the touch driver circuit to the touch lines SL1. The first switching circuit M1 may connect the touch lines SL1 connected to the touch electrodes TE with the touch connection lines SL2 connected to the pad area (touch pad area) at the ratio of n : 1, where n is an integer equal to or greater than two. According to this embodiment, the number of touch pads located in the pad area can be reduced by including the switching circuits M1 and M2.

The pad area may be located in the subsidiary area SBA and may be electrically connected to driving circuits for driving pixels and touch sensors (for example, touch electrodes TE) of the display panel 100. The pad area may include a touch pad area to which signal lines associated with the touch sensors (for example, touch connection lines SL2) are connected. The pad area may include a display pad area to which signal lines associated with driving of the pixels are connected.

The touch pad area located at a portion of the subsidiary area SBA may include touch pads connected to the circuit board 200. A touch driver circuit TIC may be directly mounted on the touch pads. For example, the touch driver circuit may be implemented as an integrated circuit (IC) and may be mounted on the touch pad area by the chip-on-glass (COG) technique, or the chip-on-plastic (COP) technique. FIG. 3 shows an embodiment in which the touch driver circuit TIC is disposed on the circuit board 200. In this instance, the touch pad area located at a position of the subsidiary area SBA may be electrically connected to the circuit board 200 through a flexible printed circuit board 310, and may include touch pad lines SL3 for connecting the touch driver circuit TIC of the circuit board 200 with the touch pad area of the subsidiary area SBA.

The display pad area located at a position of the subsidiary area SBA may include display pads connected to the circuit board 200. The display driver circuits DIC1 and DIC2 may be mounted directly on the display pads. For example, the display driver circuits DIC1 and DIC2 may be implemented as an integrated circuit (IC) and may be mounted on the touch pad area by the chip-on-glass (COG) technique, or the chip-on-plastic (COP) technique. As an example, as shown in FIG. 3, the display driver circuits DIC1 and DIC2 may be disposed on the connection substrates 320 disposed between the subsidiary area SBA and the circuit board 200. The connection substrates 320 may be flexible printed circuit boards or printed circuit boards. Although FIG. 3 shows two display driver circuits DIC1 and DIC2, the number of display driver circuits DIC1 and DIC2 is not limited herein.

The circuit board 200 may be attached on the pad area located at a portion of the subsidiary area SBA of the display panel 100 using an anisotropic conductive film (ACF). The circuit board 200 may be electrically connected to the pad area of the display panel 100. The circuit board 200 may be a flexible printed circuit board (FPCB), a printed circuit board (PCB), or a flexible film such as a chip-on-film (COF).

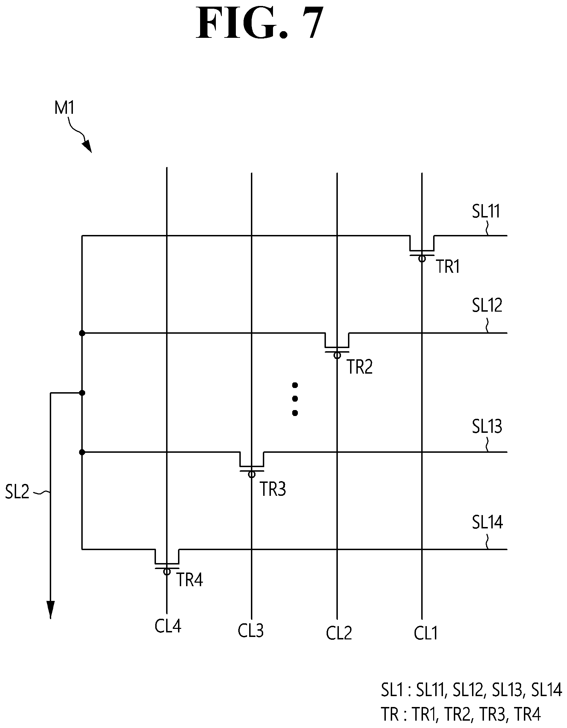

Incidentally, each of the first switching circuit M1 and the second switching circuit M2 may include thin-film transistors (for example, a switching thin-film transistor TR of FIG. 7). The switching thin-film transistors TR (see FIG. 7) included in the first switching circuit M1 and the second switching circuit M2 may be disposed on the same layer as the thin-film transistors TFT1 and TFT2 (see FIG. 5) disposed in the display area DPA to drive the pixels.

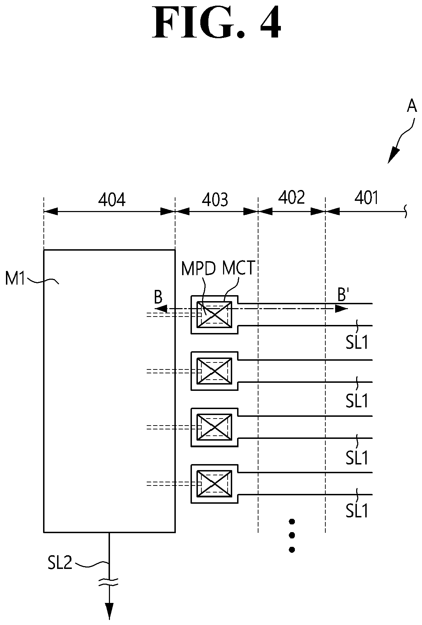

The thin-film transistors included in each of the first switching circuit M1 and the second switching circuit M2 may be referred to as switching thin-film transistors. The switching thin-film transistors TR (see FIG. 7) included in each of the first switching circuit M1 and the second switching circuit M2 may connect the touch lines SL1 connected to the touch electrodes TE with the touch connection lines SL2 connected to the pad area (touch pad area) at the ratio of n : 1, where n is an integer equal to or greater than two. To this end, the switching thin-film transistors TR included in each of the first switching circuit M1 and the second switching circuit M2 may include input pads, for example with pad contact holes MCT and pad electrodes MPD, electrically connected to the touch lines SL1. Each of the first switching circuit M1 and the second switching circuit M2 may be electrically connected to the touch electrodes TE located in the display area DPA through the input pads. The input pads connecting the switching thin-film transistors TR of the switching circuits M1 and M2 with the touch lines SL1 may be disposed in a contact area 403 spaced apart from the switching circuits M1 and M2 when viewed from the top. In the contact area 403, inorganic films may be stacked each other but no organic film is stacked. Hereinafter, the input pads connecting the switching thin-film transistors TR of the switching circuits M1 and M2 with the touch lines SL1 will be described in detail with reference to FIGS. 4 to 6.

FIG. 4 is a schematic plan view showing a non-display area NDA around switching circuits M1 and M2 according to an embodiment. For example, FIG. 4 may be a schematic plan view schematically showing area A shown in FIG. 3.

Referring to FIG. 4, the display panel 100 according to an embodiment may include switching circuits M1 and M2 to drive the touch sensors in the non-display area NDA. The switching circuits M1 and M2 may connect touch lines SL1 connected to touch electrodes TE with touch connection lines SL2 connected to the pad area (touch pad area) at the ratio of n : 1, where n is an integer equal to or greater than two.

The touch lines SL1 are connected to the touch electrodes TE in the display area DPA and are extended from the display area DPA to the non-display area NDA. The touch lines SL1 extended to the non-display area NDA are electrically connected to the switching circuits M1 and M2 through the input pads located in the contact area 403 between the switching circuits M1 and M2 and the display area DPA. The contact area 403 is located on the outer side of dams DM1 and DM2, collectively DM, in the non-display area NDA. In the contact area 403, inorganic film is disposed but no organic film is disposed.

By way of example, as shown in FIG. 4, the non-display area NDA adjacent to the switching circuits M1 and M2 may include a fan-out line area 401 in which fan-out lines are disposed; a dam area 402 located on the outer side of the fan-out line area 401 where dams DM1 and DM2 is disposed; a contact area 403 located on the outer side of the dam area 402; and a switching circuit area 404 located on the outer side of the contact area 403 where the switching circuits M1 and M2 are disposed. In the foregoing description, the outer side refers to the side in the direction from the center of the display area DPA toward the non-display area NDA. For example, in FIG. 4, the right direction is the center direction of the display area DPA, while the left direction is the outer boundary direction of the non-display area NDA. Accordingly, in FIG. 4, the outer side refers to the left direction.

Referring to FIG. 4, the touch lines SL1 extended to the non-display area NDA may be extended to input pads disposed in the contact area 403 via the fan-out line area 401 and the dam area 402. The touch lines SL1 are connected to the input pads in the contact area 403.

The input pads may include pad electrodes MPD connected to the switching thin-film transistors TR of the switching circuits M1 and M2, and pad contact holes MCT exposing the upper surfaces of the pad electrodes MPD. The pad electrodes MPD may be disposed in the same layer as the gate electrode G2 (see FIG. 5) of the thin-film transistor (for example, the transistor TFT2 of FIG. 5) disposed in the display area DPA. The pad contact holes MCT penetrate the inorganic films disposed in the contact area 403 to expose the upper surfaces of the pad electrodes MPD. In each of the input pads, the touch lines SL1 extended to the contact area 403 may cover the pad electrode MPD through the pad contact hole MCT. Accordingly, the touch lines SL1 may be electrically connected to the pad electrodes MPD. Herein, the pad electrodes MPD may be connected to the switching thin-film transistors TR (see FIG. 7) included in the switching circuits M1 and M2.

The switching thin-film transistors TR in the switching circuits M1 and M2 may be electrically connected to the touch lines SL1 through the input pads, and may connect them with touch connection lines SL2 connected to the pad area (touch pad area) at the ratio of n : 1, where n is an integer equal to or greater than two.

Hereinafter, inorganic films disposed in the contact area 403 will be described in more detail with reference to FIG. 5. It should be noted that the top layer among the inorganic films disposed in the contact area 403 may be a third interlayer dielectric film 550 described with reference to FIG. 5. In the contact area 403, organic films such as a first planarization film 560, a second planarization film 570 and a first planarization film 580 disposed on the third interlayer dielectric film 550 described with reference to FIG. 5 are not disposed. The pad electrodes MPD of the input pads described above with reference to FIG. 4 may be formed in the same layer as the second gate electrode G2 shown in FIG. 5.

FIG. 5 is a schematic cross-sectional view showing a cross section of a display area DPA of a display panel 100 according to an embodiment. In the descriptions associated with FIG. 5, the phrase that different elements overlap one another may mean that they overlap one another in the z-direction of FIG. 5. The z-direction may be the third direction DR3 described above with reference to FIGS. 1 and 2.

Referring to FIG. 5, the display area DPA of the display panel 100 may include a cross-sectional stack structure as follows:
The display panel 100 may include a substrate SUB, a thin-film transistor layer disposed on the substrate SUB, a planarization layer disposed on the thin-film transistor layer, an OLED layer disposed on the planarization layer, an encapsulation layer disposed on the OLED layer, and a touch sensor layer disposed on the encapsulation layer. The thin-film transistor layer may include a first thin-film transistor TFT1, and a second thin-film transistor TFT2 disposed on the first thin-film transistor TFT1. The planarization layer may include organic films 560, 570 and 580. A light-emitting element, for example, an OLED, may include an anode electrode 571, an emissive layer 572, and a cathode electrode 573. The encapsulation layer TFE may include at least one organic encapsulation film TFE2 and at least one inorganic encapsulation film TFE1 and TFE3. The touch sensor layer may include self-capacitance detection touch electrodes TE, and touch lines SL1 (see FIG. 4) connected to the touch electrodes TE.

The substrate SUB may be made of an insulating material such as a polymer resin. For example, the substrate SUB may be made of polyimide. The substrate SUB may be a flexible substrate that can be bent, folded, or rolled. At least one buffer layer BF1 and BF2 and at least one second substrate SUB2 may be further disposed on the substrate SUB, but the invention is not limited thereto.

A first active layer ACT1 of the first thin-film transistor TFT1 may be disposed on the second buffer layer BF2. The first active layer ACT1 of the first thin-film transistor TFT1 may include polycrystalline silicon, monocrystalline silicon, low-temperature polycrystalline silicon, amorphous silicon, or oxide semiconductor.

The first active layer ACT1 may include a first source region S1 and a first drain region D1, and a channel region may be formed therebetween. The channel region may overlap a first gate electrode G1. The first source region S1 and the first drain region D1 may have conductivity by doping a silicon semiconductor or an oxide semiconductor with ions or impurities.

A first gate insulator 530 may be disposed on the first active layer ACT1 of the first thin-film transistor TFT1. The first gate insulator 530 may be formed of an inorganic layer, for example, a silicon nitride layer, a silicon oxynitride layer, a silicon oxide layer, a titanium oxide layer, or an aluminum oxide layer.

The first gate electrode G1 of the first thin-film transistor TFT1 and a first capacitor electrode CAE1 may be disposed on the gate insulator 530. The first gate electrode G1 may overlap the first active layer ACT1. The first gate electrode G1 and the capacitor electrode CAE1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first interlayer dielectric film 541 may be disposed on the first gate electrode G1 of the first thin-film transistor TFT1 and the first capacitor electrode CAE1. The first interlayer dielectric film 541 may be formed of an inorganic layer, for example, a silicon nitride layer, a silicon oxynitride layer, a silicon oxide layer, a titanium oxide layer, or an aluminum oxide layer. The first interlayer dielectric film 541 may be made of inorganic films.

The second capacitor electrode CAE2 may be disposed on the first interlayer dielectric layer 541. The second capacitor electrode CAE2 may overlap the first capacitor electrode CAE1 of the first thin-film transistor TFT1. In case that the first capacitor electrode CAE1 is connected to the first gate electrode G1, the second capacitor electrode CAE2 may overlap the first gate electrode G1 in the third direction DR3. Since the first interlayer dielectric layer 541 has a selectable dielectric constant, a capacitor can be formed by the first capacitor electrode CAE1, the second capacitor electrode CAE2 and the first interlayer dielectric layer 541 disposed therebetween. The second capacitor electrode CAE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second interlayer dielectric layer 542 may be disposed over the second capacitor electrode CAE2. The second interlayer dielectric film 542 may be formed of an inorganic layer, for example, a silicon nitride layer, a silicon oxynitride layer, a silicon oxide layer, a titanium oxide layer, or an aluminum oxide layer. The second interlayer dielectric film 542 may be made of inorganic films.

A second active layer ACT2 of the second thin-film transistor TFT2 may be disposed on the second interlayer dielectric film 542. The second active layer ACT2 may include an oxide semiconductor. For example, the second active layer ACT2 may include IGZO (Indium (In), Gallium (Ga), Zinc (Zn) and Oxygen (O)), IGZTO (Indium (In), Gallium (Ga), Zinc (Zn), Tin (Sn) and Oxygen (O)) or IGTO (indium (In), gallium (Ga), tin (Sn) and oxygen (O)).

The second active layer ACT2 may include a second source region S2 and a second drain region D2, and a second channel region may be formed therebetween. The second channel region may overlap a second gate electrode G2. The second source region S2 and the second drain region D2 may have conductivity by doping an oxide semiconductor with ions or impurities.

A second gate insulator 531 may be disposed on the second active layer ACT2 of the second thin-film transistor TFT2. The second gate insulator 531 may be formed of an inorganic layer, for example, a silicon nitride layer, a silicon oxynitride layer, a silicon oxide layer, a titanium oxide layer, or an aluminum oxide layer.

The second gate electrode G2 of the second thin-film transistor TFT2 may be disposed on a second gate insulator 531. The second gate electrode G2 may overlap the second active layer ACT2. The second gate electrode G2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof. In the same layer as the second gate electrode G2 of the second thin-film transistor TFT2, the pad electrodes MPD connecting the switching thin-film transistors TR of the switching circuits M1 and M2 with the touch lines SL1 may be formed at a portion of the non-display area NDA.

A third interlayer dielectric film 550 may be disposed on the second gate electrode G2 of the second thin-film transistor TFT2. The third interlayer dielectric film 550 may be formed of an inorganic layer, for example, a silicon nitride layer, a silicon oxynitride layer, a silicon oxide layer, a titanium oxide layer, or an aluminum oxide layer. The third interlayer dielectric film 550 may be made of inorganic films.

A first anode connection electrode ANDE1, a first bridge electrode BE1 and a second bridge electrode BE2 may be disposed on the third interlayer dielectric layer 550. The first anode connection electrode ANDE1 may be connected to the first drain region D1 of the first active layer ACT1 through a first anode contact hole ANCT1 penetrating the first interlayer dielectric film 541, the second interlayer dielectric film 542, the second gate insulator 531 and the third interlayer dielectric film 550. The first bridge electrode BE1 may be connected to the second source region S2 of the second active layer ACT2 through a first connection contact hole BCT1 penetrating through the third interlayer dielectric film 550. The second bridge electrode BE2 may be connected to the second drain region D2 of the second active layer ACT2 through a second connection contact hole BCT2 penetrating through the third interlayer dielectric film 550. Each of the first anode connection electrode ANDE1, the first bridge electrode BE1 and the second bridge electrode BE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first planarization film 560 may be disposed over the first anode connection electrode ANDE1 for providing a flat surface over level differences due to the first thin-film transistor TFT1. The first planarization film 560 may be formed of an organic layer such as an acryl resin, an epoxy resin, a phenolic resin, a polyamide resin and a polyimide resin.

A second anode connection electrode ANDE2 may be disposed on the first planarization film 560. The second anode connection electrode ANDE2 may be connected to the first anode connection electrode ANDE1 through a second connection contact hole ANCT2 penetrating the first planarization film 560. The second anode connection electrode ANDE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second planarization film 570 may be disposed on the second anode connection electrode ANDE2. The second planarization film 570 may be formed as an organic layer such as an acryl resin, an epoxy resin, a phenolic resin, a polyamide resin and a polyimide resin.

A third anode connection electrode ANDE3 may be disposed on the second planarization film 570. The third anode connection electrode ANDE3 may be connected to the second anode connection electrode ANDE2 through a third connection contact hole ANCT3 penetrating the second planarization film 570. The third anode connection electrode ANDE3 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A third planarization film 580 may be disposed on the third anode connection electrode ANDE3. The third planarization film 580 may be formed as an organic layer such as an acryl resin, an epoxy resin, a phenolic resin, a polyamide resin and a polyimide resin.

An OLED may be formed on the third planarization film 580. By way of example, light-emitting elements LEL and a bank (or pixel-defining film) 590 may be disposed on the third planarization film 580. Each of the light-emitting elements LEL may include a pixel electrode (for example, an anode electrode) 571, an emissive layer 572, and a common electrode (for example, a cathode electrode) 573.

The pixel electrode (for example, the anode electrode 571) may be disposed on the third planarization film 580. The pixel electrode 571 may be connected to the third anode connection electrode ANDE3 through a fourth connection contact hole ANCT4 penetrating the third planarization film 580.

In the top-emission structure in which light exits from the emissive layer 572 toward the common electrode 573, the pixel electrode 571 may be made of a metal material having a high reflectivity such as a stack structure of aluminum and titanium (Ti / Al / Ti), a stack structure of aluminum and indium tin oxide (ITO) (ITO / Al / ITO), an APC alloy and a stack structure of APC alloy and ITO (ITO / APC / ITO). The APC alloy is an alloy of silver (Ag), palladium (Pd) and copper (Cu).

The bank 590 may be formed to partition the pixel electrode 571 on the third planarization film 580. The bank 590 may be disposed to cover the edges of the pixel electrode 571. The bank 590 may be formed of an organic layer such as an acryl resin, an epoxy resin, a phenolic resin, a polyamide resin and a polyimide resin.

The emissive layer 572 may be disposed on the pixel electrode 571 and the bank 590. The emissive layer 572 may include an organic material to emit light of a given color. For example, the emissive layer 572 may include a hole transporting layer, an organic material layer, and an electron transporting layer.

A common electrode (for example, a cathode electrode) 573 may be disposed on the emissive layer 572. The common electrode 573 may be disposed to cover the emissive layer 572.

In the top-emission organic light-emitting diode, the common electrode 573 may be formed of a transparent conductive material (TCP) such as ITO and IZO that can transmit light, or a semi-transmissive conductive material such as magnesium (Mg), silver (Ag) and an alloy of magnesium (Mg) and silver (Ag). In case that the common electrode 573 is formed of a semi-transmissive metal material, the light extraction efficiency can be increased by using microcavities.

A spacer 590 may be disposed on the bank 591. The spacer 591 may support a mask during a process of fabricating the emission layer 572. The spacer 591 may be formed of an organic layer such as an acryl resin, an epoxy resin, a phenolic resin, a polyamide resin and a polyimide resin.

An encapsulation layer TFE may be disposed on the common electrode 573. The encapsulation layer TFE may include at least one inorganic film to prevent permeation of oxygen or moisture into the emissive layer 572. The encapsulation layer TFE may include at least one organic layer to protect the emissive layer 572 from foreign substances such as dust. For example, the encapsulation layer TFE may include a first inorganic encapsulation film TFE1, an organic encapsulation film TFE2 and a second inorganic encapsulation layer TFE3.

The first inorganic encapsulation film TFE1 may be disposed on the common electrode 573, the organic encapsulation film TFE2 may be disposed on the first inorganic encapsulation film TFE1, and the second inorganic encapsulation film TFE3 may be disposed on the organic encapsulation film TFE2. The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer may be alternately stacked each other. The organic encapsulation film TFE2 may be an organic film such as an acryl resin, an epoxy resin, a phenolic resin, a polyamide resin, a polyimide resin, etc.

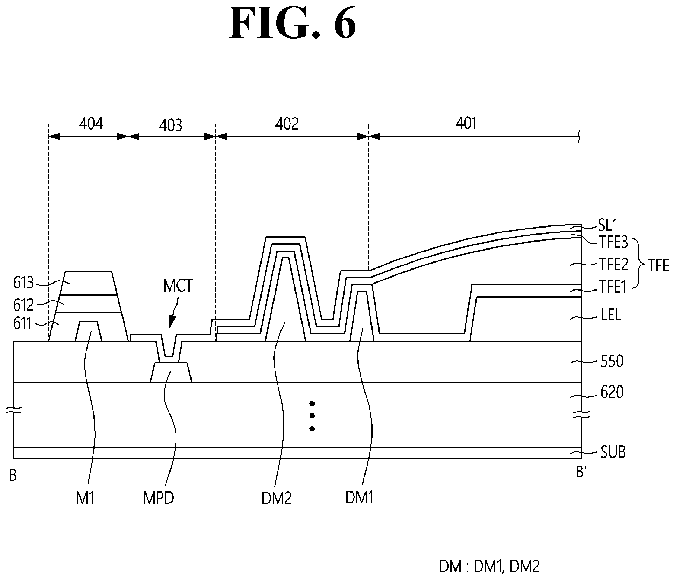

A touch sensor (for example, a touch electrode TE) may be disposed on the encapsulation layer TFE. For example, touch electrodes TE and touch lines SL1 (see FIGS. 4 and 6) connected to the touch electrodes TE are disposed on the second inorganic encapsulation film TFE3.

A touch insulating film is formed on the touch electrodes TE. The touch insulating film may be formed of an organic layer such as an acryl resin, an epoxy resin, a phenolic resin, a polyamide resin and a polyimide resin.

As will be described below, one pixel, for example, one sub-pixel SP may include at least one first thin-film transistor TFT1, at least one second thin-film transistor TFT2, and a light-emitting element LEL.

FIG. 6 is a schematic cross-sectional view showing an example of the display panel 100, taken along line B - B' shown in FIG. 4.

FIG. 6 schematically shows a lower structure (for example, a backplane structure) of the display panel 100, for example, the layers under or below a light-emitting element of an OLED. In FIG. 6, a thin-film transistor layer 620 is disposed on the substrate. In FIG. 6, the third interlayer dielectric film 550 described above with reference to FIG. 6 is disposed on the thin-film transistor layer 620. Although not shown in the drawings, in the display area DPA, organic films may be disposed between the light-emitting layer LEL and the third interlayer dielectric film 550 in FIG. 6. For example, as organic films, a first planarization film 560, a second planarization film 570 and a third planarization film 580 may be disposed between the light-emitting layer LEL and the third interlayer dielectric film 550. These organic films 560, 570 and 580 are not disposed in the contact area 403.

Referring to FIGS. 4 to 6, in the display panel 100, a thin-film transistor layer may be disposed on the substrate SUB. The thin-film transistor layer may include a first thin-film transistor TFT1 (see FIG. 5), and a second thin-film transistor TFT2 (see FIG. 5) disposed on the first thin-film transistor TFT1. As described above with reference to FIG. 5, the thin-film transistor layer may include the active layer ACT1 of the first thin-film transistor, and inorganic films 530 and 540 for insulating the electrodes G1 from each other. As described above with reference to FIG. 5, the thin-film transistor layer may include the active layer ACT2 of the second thin-film transistor, and inorganic films 531 and 550 for insulating the electrodes G2 from each other.

Although not shown in FIG. 6, the planarization layers 560, 570 and 580 (see FIG. 5) may be disposed on the thin-film transistor layer in the display area DPA, and an OLED layer including light-emitting elements LEL may be disposed on the planarization layers 560, 570 and 580 (see FIG. 5). The encapsulation layer TFE may be disposed on the OLED layer, and the touch sensor layer TINS including touch electrodes TE may be disposed on the encapsulation layer TFE.

The touch lines SL1 are disposed on the same layer as the touch electrodes TE of the touch sensor layer. The touch lines SL1 may be extended to the non-display area NDA. The touch lines SL1 extended to the non-display area NDA are electrically connected to the switching circuits M1 and M2 through the input pads located in the contact area 403 between the switching circuits M1 and M2 and the display area DPA. The contact area 403 is located on the outer side of dams DM1 and DM2 in the non-display area NDA. In the contact area 403, inorganic film is disposed but no organic film is disposed.

As shown in FIG. 6, the non-display area NDA adjacent to the switching circuits M1 and M2 may include a fan-out line area 401 in which fan-out lines are disposed; a dam area 402 located on the outer side of the fan-out line area 401 where dams DM1 and DM2 is disposed; a contact area 403 located on the outer side of the dam area 402; and a switching circuit area 404 located on the outer side of the contact area 403 where the switching thin-film transistors TR of the switching circuits M1 and M2 are disposed. In the foregoing description, the outer side refers to the side in the direction from the center of the display area DPA toward the non-display area NDA. For example, in FIG. 6, the right direction is the center direction of the display area DPA, while the left direction is the outer boundary direction of the non-display area NDA. Accordingly, in FIG. 6, the outer side refers to the left direction.

Dams DM may be disposed in the dam area 402. For example, in the dam area 402, a first dam DM1 closer to the display area DPA, and a second dam DM2 on the outer side of the first dam DM1. Although FIG. 6 shows the two dams DM1 and DM2, the invention is not limited thereto. The first dam DM1 and the second dam DM2 may be formed by combining organic films included in the display panel 100. For example, each of the first dam DM1 and the second dam DM2 may be formed by a combination of organic films included in the planarization layers 560, 570 and 580 (see FIG. 5). The first dam DM1 and the second dam DM2 may further include a metal disposed in the same layer as at least one metal layer among metal layers disposed in the display area DPA. Such dams DM1 and DM2 may serve to prevent the organic film TFE2 included in the encapsulation layer TFE from spreading to the outside.

The touch lines SL1 connected to the touch electrodes TE of the touch sensor layer may be extended to the contact area 403 via the fan-out line area 401 and the dam area 402. By way of example, the touch lines SL1 extended to the non-display area NDA may be extended to input pads disposed in the contact area 403 via the fan-out line area 401 and the dam area 402. The touch lines SL1 are connected to the input pads in the contact area 403.

The input pads may include pad electrodes MPD connected to the switching thin-film transistors TR of the switching circuits M1 and M2, and pad contact holes MCT exposing the upper surfaces of the pad electrodes MPD. The pad electrodes MPD may be disposed in the same layer as the gate electrode G2 (see FIG. 5) of the thin-film transistor (the transistor TFT2 of FIG. 5) disposed in the display area DPA. For example, in the display area DPA, the first thin-film transistor TFT1 may be disposed, and a first inorganic film 541 (see FIG. 5) may be disposed on the first gate electrode G1 of the first thin-film transistor TFT1. In the display area DPA, the second thin-film transistor TFT2 may be disposed on the first thin-film transistor TFT1, and the second inorganic film 550 (see FIG. 5) may be disposed on the second gate electrode G2 of the second thin-film transistor TFT2. The pad electrode MPD disposed in the contact area 403 may be disposed in the same layer as the second gate electrode G2. Accordingly, the pad electrode MPD may be covered by the second inorganic film 550 (see FIG. 5) disposed on the second gate electrode G2. The pad contact hole MCT may pass through the second inorganic film 550 (see FIG. 5) to expose at least a part of the upper surface of the pad electrode MPD covered by the second inorganic film 550 (see FIG. 5).

The touch lines SL1 extended to the contact area 403 may cover the pad electrode MPD through the pad contact hole MCT in each of the input pads. Accordingly, the touch lines SL1 may be electrically connected to the pad electrodes MPD. Herein, the pad electrodes MPD may be connected to the switching thin-film transistors TR (see FIG. 7) included in the switching circuits M1 and M2.

The switching circuit area 404 may be located on the outer side of the contact area 403, where the switching circuits M1 and M2 connected to the input pads may be disposed. The switching circuits M1 and M2 may include switching thin-film transistors TR (see FIG. 7) connected to the touch lines SL1 through the input pads. As described later with reference to FIG. 7, the switching thin-film transistor TR may include switching thin-film transistors TR1, TR2, TR3 and TR4 (see FIG. 7). The switching thin-film transistors TR1, TR2, TR3 and TR4 included in the switching thin-film transistors TR may be disposed in the same layer as one of the first thin-film transistor TFT1 and the second thin-film transistor TFT2 disposed in the display area DPA. Organic films 611, 612 and 613 may be disposed on such switching thin-film transistors TR. Organic films 611, 612 and 613 disposed on the switching thin-film transistors TR may be formed in the same layer as the planarization films 560, 570 and 580 (see FIG. 5) disposed in the display area DPA. The organic films 611, 612 and 613 disposed on the switching thin-film transistors TR of the switching circuits M1 and M2 can protect the switching thin-film transistors TR.

According to this embodiment, in the non-display area NDA, the input pads connecting the switching thin-film transistors TR of the switching circuits M1 and M2 with the touch lines SL1 may be disposed in the contact area 403 where no organic film is disposed. Accordingly, the pad contact hole MCT is formed to penetrate only the inorganic films without any organic film, and thus it is possible to prevent delamination defects that may occur during the process of fabricating the display panel 100. Delamination defects may occur during the process of fabricating the display panel 100 due to the height difference between the organic films (for example, the films 611, 612 and 613) between the pad electrodes MPD and the touch lines SL1. This may cause disconnection of the touch lines SL1 or short-circuit. According to this embodiment, the input pads are disposed in the contact area 403, so that it is possible to prevent delamination defects that may occur during the process of fabricating the display panel 100.

FIG. 7 is a schematic circuit diagram showing an example of switching thin-film transistors TR of switching circuits M1 and M2 according to an embodiment. For example, FIG. 7 may be a schematic circuit diagram showing a part of the switching thin-film transistors TR included in the switching circuits M1 and M2 described above with reference to FIGS. 4 and 6.

Referring to FIG. 7, the switching thin-film transistors TR of the switching circuits M1 and M2 may include switching thin-film transistors TR1, TR2, TR3 and TR4 (see FIG. 7). The switching thin-film transistors TR1, TR2, TR3 and TR4 may be electrically connected to the touch lines SL1 through the input pads, and may connect them with touch connection lines SL2 connected to the pad area (touch pad area) at the ratio of n : 1, where n is an integer equal to or greater than two. To this end, the switching thin-film transistors TR include switching groups that connect the touch lines SL1 with the touch connection lines SL2 at the ratio of n : 1, where n is an integer equal to or greater than two. Each of the switching groups may include n switching thin-film transistors TR1, TR2, TR3 and TR4. For example, each switching group may include four switching thin-film transistors TR1, TR2, TR3 and TR4, but this is illustrative.

One switching group may include four switching thin-film transistors TR1, TR2, TR3 and TR4, including a first switching thin-film transistor TR1, a second switching thin-film transistor TR2, a third switching thin-film transistor TR3, and a fourth switching thin-film transistor TR4.

The first switching thin-film transistor TR1 may be turned on or off in response to a first control signal of a first control signal line CL1 and may connect a first touch line SL11 with a touch connection line SL2 when turned on.

The second switching thin-film transistor TR2 may be turned on or off in response to a second control signal of a second control signal line CL2 and may connect a second touch line SL12 with a touch connection line SL2 when turned on.

The third switching thin-film transistor TR3 may be turned on or off in response to a third control signal of a third control signal line CL3 and may connect a third touch line SL13 with a touch connection line SL2 when turned on.

The fourth switching thin-film transistor TR4 may be turned on or off in response to a fourth control signal of a fourth control signal line CL4 and may connect a fourth touch line SL14 with a touch connection line SL2 when turned on.

The first to fourth control signals may be output at different timings. For example, while the first control signal is being output, the second to fourth control signals may not be output. Accordingly, the switching thin-film transistors in each switching group may be turned on sequentially, to thereby connect the touch lines SL1 with the touch connection lines SL2 at the ratio of n : 1, where n is an integer equal to or greater than two.

Referring to FIG. 7, the switching thin-film transistors TR1, TR2, TR3 and TR4 may be implemented as p-type MOSFETs. However, this is illustrative, and the invention is not limited thereto. For example, the switching thin-film transistors TR1, TR2, TR3 and TR4 may be implemented as n-type MOSFETs.

Incidentally, the switching thin-film transistors TR1, TR2, TR3 and TR4 described above with reference to FIG. 7 may be disposed in the same layer as one of the first thin-film transistor TFT1 and the second thin-film transistor TFT2 disposed in the display area DPA. Organic films 611, 612, and 613 (see FIG. 6) may be disposed over them. Organic films 611, 612 and 613 (see FIG. 6) disposed on the switching thin-film transistor TR may be formed in the same layer as the planarization films 560, 570 and 580 (see FIG. 5) disposed in the display area DPA.

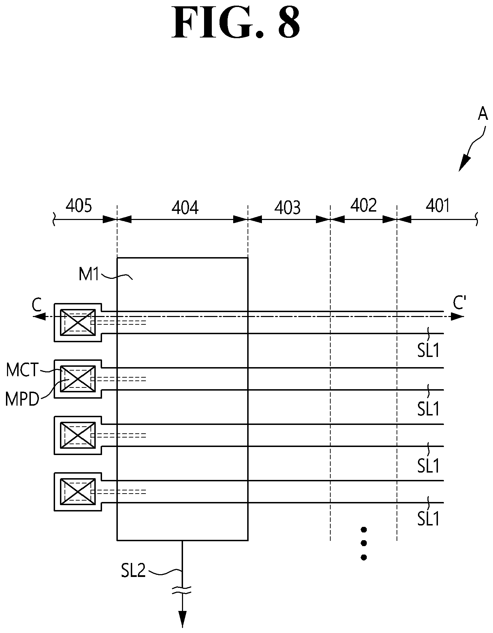

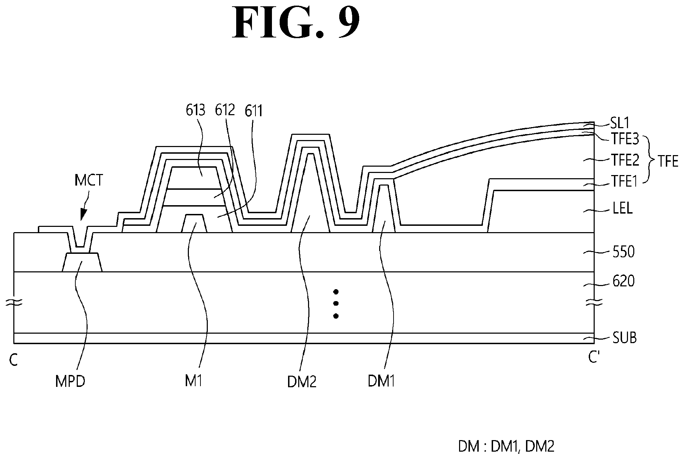

According to an embodiment, the input pads connecting the switching circuits M1 and M2 with the touch lines SL1 may be disposed on the outer side of the switching circuits M1 and M2. Hereinafter, referring to FIGS. 8 and 9, an embodiment in which input pads connecting the switching circuits M1 and M2 with the touch lines SL1 are disposed outside the switching circuits M1 and M2 will be described.

FIG. 8 is a schematic plan view showing input pads connected to switching circuits M1 and M2 according to an embodiment. FIG. 9 is a schematic cross-sectional view showing an example of the display panel 100, taken line C - C' shown in FIG. 8.

The embodiment of FIGS. 8 and 9 may be at least partially similar to the embodiment of FIG. 4 to 6. The following description will focus on the differences. The components identical to those described in the embodiment of FIGS. 4 and 5 will not be described again.

According to the embodiment of FIGS. 8 and 9, input pads, for example with pad contact holes MCT and pad electrodes MPD, connecting switching circuits M1 and M2 with touch lines SL1 are disposed outside the switching circuits M1 and M2, unlike the embodiment of FIGS. 4 to 6. For example, the input pads of the switching circuits M1 and M2 may be disposed in a contact area 405 outside the switching circuits M1 and M2 (for example, a second contact area 405) instead of the contact area 403 between the switching circuit area 404 and the dam area 402 (for example, a first contact area 403). Similar to the contact area 403 described above with reference to FIGS. 4 and 6, inorganic film may be disposed but no organic film may be disposed in the contact area 405 shown in FIGS. 8 and 9.

Referring to FIGS. 8 and 9, a pad electrode MPD may be disposed in the contact area 405 on the outer side of the switching circuit area 404. The contact area 405 may be located between the switching circuits M1 and M2 and the border of the non-display area NDA on the outer side of the switching circuits M1 and M2, for example, the switching circuit area 404.

The pad electrodes MPD may be connected to the switching thin-film transistors TR of the switching circuits M1 and M2 and may be disposed in the same layer as the gate electrode G2 (see FIG. 5) of the thin-film transistor (the transistor TFT2 of FIG. 5) disposed in the display area DPA. For example, in the display area DPA, the first thin-film transistor TFT1 may be disposed, and a first inorganic film 541 (see FIG. 5) may be disposed on the first gate electrode G1 of the first thin-film transistor TFT1. In the display area DPA, the second thin-film transistor TFT2 may be disposed on the first thin-film transistor TFT1, and the second inorganic film 550 (see FIG. 5) may be disposed on the second gate electrode G2 of the second thin-film transistor TFT2. The pad electrodes MPD disposed in the contact area 405 located on the outer side of the switching circuit area 404 may be disposed in the same layer as the second gate electrode G2. Accordingly, the pad electrode MPD may be covered by the second inorganic film 550 (see FIG. 5) disposed on the second gate electrode G2. The pad contact hole MCT may pass through the second inorganic film 550 (see FIG. 5) to expose at least a part of the upper surface of the pad electrode MPD covered by the second inorganic film 550 (see FIG. 5).

The touch lines SL1 are extended to the contact area 405 via the switching circuits M1 and M2, for example, the switching circuit area 404. The touch lines SL1 extended to the contact area 405 may cover the pad electrode MPD through the pad contact hole MCT in each of the input pads. Accordingly, the touch lines SL1 may be electrically connected to the pad electrodes MPD.

According to this embodiment, in the non-display area NDA, the input pads connecting the switching thin-film transistors TR of the switching circuits M1 and M2 with the touch lines SL1 are disposed in the contact area 405 outside the switching circuits M1 and M2 where no organic film is disposed. Accordingly, the pad contact hole MCT is formed to penetrate only the inorganic films without any organic film, and thus it is possible to prevent delamination defects that may occur during the process of fabricating the display panel 100. Delamination defects may occur during the process of fabricating the display panel 100 due to the height difference between the organic films (for example, the films 611, 612 and 613 of FIG. 9) between the pad electrodes MPD and the touch lines SL1. This may cause disconnection of the touch lines SL1 or short-circuit. According to this embodiment, the input pads are disposed in the contact area 405, so that it is possible to prevent delamination defects that may occur during the process of fabricating the display panel 100.

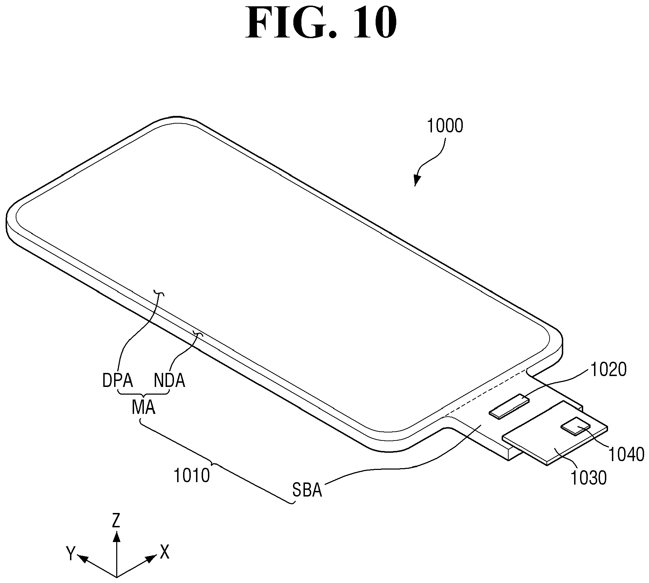

It should be noted that the display device does not necessarily include the slidable display panel 100 described above with reference to FIGS. 1 and 2. For example, the display device may include a bar-type display panel (for example, a display panel 1010 in FIG. 10) that is not folded, bent, or curved. The display panel 1010 (see FIG. 10) may include self-capacitance detection touch electrodes TE. Such touch electrodes TE may be connected to a pad area through touch lines SL1 and switching circuits M1 and M2. In this instance, the input pads of the switching circuits M1 and M2 may be disposed in the contact area 403 as described above with reference to FIGS. 4 to 9. Hereinafter, a display device including the bar-type display panel 100 according to an embodiment will be described in detail with reference to FIGS. 10 to 13.

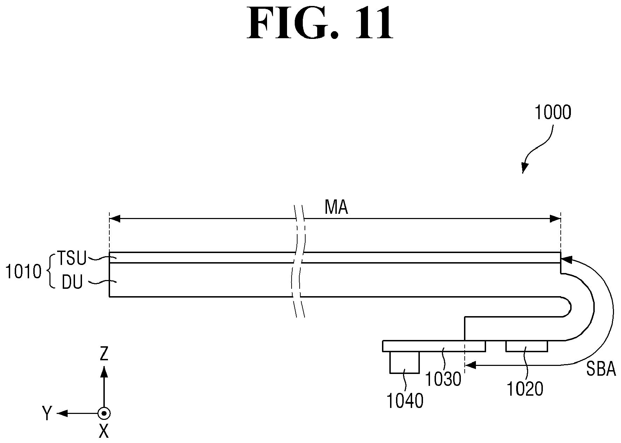

FIG. 10 is a schematic perspective view of a display device according to an embodiment. FIG. 11 is a schematic cross-sectional view of the display device shown in FIG. 10.

In the drawings, a first direction X refers to a direction parallel to a side of the display device 1000 when viewed from the top, for example, the shorter side direction of the display device 1000. A second direction Y refers to a direction parallel to another side of the display device 1000 that meets the side when viewed from the top, for example, the longer side direction of the display device 1000. A third direction Z refers to the thickness direction of the display device 1000. It should be understood that the directions referred to in the embodiments are relative directions, and the embodiments are not limited to the directions mentioned.

Referring to FIG. 10, the display device 1000 may have a shape similar to a rectangle when viewed from the top. For example, the display device 1000 may have a shape similar to a quadrangle having shorter sides in the first direction X and longer sides in the second direction Y when viewed from the top. The corners where the shorter sides in the first direction X meet the longer sides in the second direction Y may be rounded with a selectable curvature or may be a right angle. The shape of the display device 1000 when viewed from the top is not limited to a rectangular shape, but may have a shape similar to other polygonal shapes, a circular shape, or an elliptical shape.

At least one of the front surface and the rear surface of the display device 1000 may be a display surface. As used herein, the front surface refers to the surface located on one side or a side of a plane, for example, the surface located on the side indicated by the arrow of the third direction Z in the drawings. The rear surface refers to the surface located on the opposite side of the plane, for example, the surface located on the opposite side to the side indicated by the arrow of the third direction Z in the drawings. The display device 1000 may be a double-sided display device 1000 in which images can be displayed on both the front and rear surfaces. In the following description, the display surface is located on the front side of the display device 1000 according to the embodiment.

The display device 1000 may include a display panel 1010 providing a display screen, a display driver circuit 1020, a circuit board 1030 and a touch driver circuit 1040.

The display panel 1010 may have a shape similarly to a rectangular shape when viewed from the top. For example, the display panel 1010 may have a shape similar to a quadrangle having shorter sides in the first direction X and longer sides in the second direction Y when viewed from the top. The corners where the shorter sides in the first direction X meet the longer sides in the second direction Y may be rounded with a selectable curvature or may be a right angle. The shape of the display panel 1010 when viewed from the top is not limited to a rectangular shape, but may have a shape similar to other polygonal shapes, a circular shape, or an elliptical shape.

The display panel 1010 may include a main area MA and a subsidiary area SBA.

The main area MA may include the display area DPA including pixels for displaying images, and the non-display area NDA located around the display area DPA. The display area DPA may emit light from emission areas or opening areas. For example, the display panel 1010 may include pixel circuits, a pixel-defining film that defines emission areas or open areas, and self-light-emitting elements.

The non-display area NDA may be disposed on the outer side of the display area DPA. The non-display area NDA may be defined as the edge area of the main area MA of the display panel 1010. The non-display area NDA may include a gate driver (not shown) supplying gate signals to gate lines (not shown) of the display panel 1010.

The subsidiary area SBA may be extended from one side or a side of the main area MA. The subsidiary area SBA may be bent such that it overlaps the main area MA in the third direction Z. The subsidiary area SBA may include the pad area connected to the display driver circuit 1020 and the circuit board 1030.

The display panel 1010 may include a display unit DU and a touch unit TSU.

The display unit DU may include pixels PX. Each of the pixels PX is a unit for displaying an image. One pixel PX may include, but is not limited to, a red sub-pixel, a green sub-pixel and a blue sub-pixel. The pixels PX may be arranged alternately when viewed from the top. For example, the pixels PX may be arranged in, but is not limited to, a matrix.

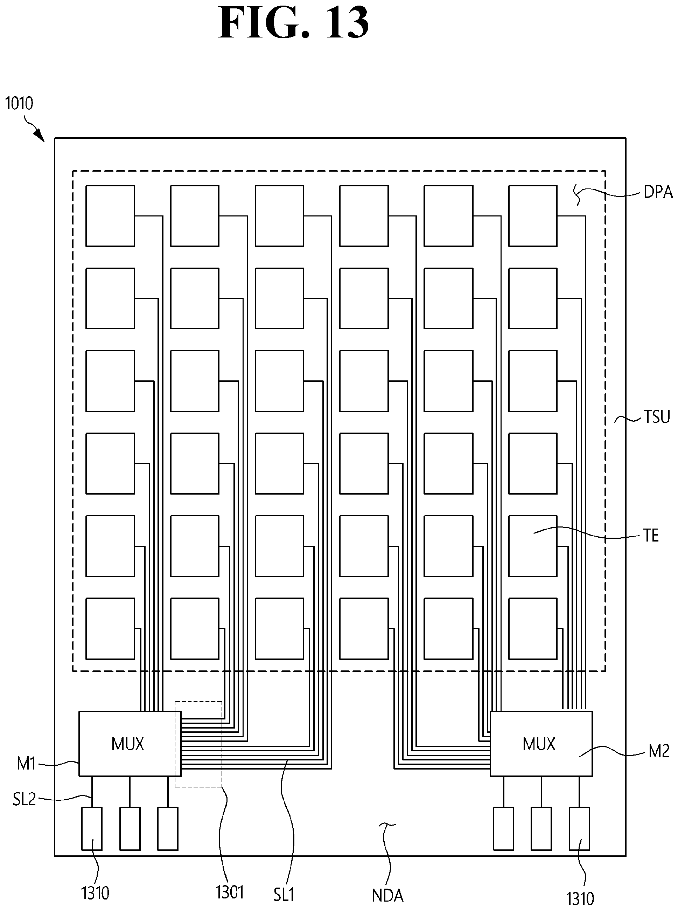

The touch unit (for example, touch sensor layer) TSU may be disposed on the display unit DU. The touch unit TSU may include touch electrodes TE (the electrodes TE in FIG. 13) for sensing a user's touch by self-capacitance sensing; touch lines SL1 connected to the touch electrodes TE; switching circuits M1 and M2 connected to the touch lines SL1; and the touch connection lines SL2 connected to the touch lines SL1 through the switching circuits M1 and M2 and extended to the touch pad area. The touch unit TSU is a layer that detects a touch input and may work as a touch member. The touch unit TSU may determine whether there is a touch input and may calculate touch input coordinates of the position, if any.

The display unit DU and the touch unit TSU may overlap each other. For example, the display area DPA may display images on the screen and may detect a touch input.

The subsidiary area SBA of the display panel 1010 may be extended from one side or a side of the main area MA. The subsidiary area SUB may include a flexible material that can be bent, folded, or rolled. For example, a part of the subsidiary area SBA may be bent on one side or a side of the main area MA, and another part of the subsidiary area SBA extended from the bent part of the subsidiary area SBA may overlap the main area MA in the third direction (z-axis direction). The subsidiary area SBA may include the pad area connected to the display driver circuit 1020 and the circuit board 1030. The pad area may include a display pad area connected to the display driver circuit 1020 and a touch pad area connected to the touch driver circuit 1040.

The display driver circuit 1020 may be disposed in the subsidiary area SBA of the display panel 1010. The display driver circuit 1020 may be implemented as an integrated circuit (IC) and may be mounted on the display panel 1010 by the chip-on-glass (COG) technique, or the chip-on-plastic (COP) technique.

The display driver circuit 1020 may output data signals and voltages for driving the display panel 1010. The display driver circuit 1020 may supply data voltages to data lines (not shown) of the display panel 1010. The display driver circuit 1020 may provide supply voltages to voltage lines of the display panel 1010 and may provide gate control signals to the gate driver.

The circuit board 1030 may be disposed in the subsidiary area SBA of the display panel 1010. Lead lines (not shown) of the circuit board 1030 may be electrically connected to the pad area of the display panel 1010. The circuit board 1030 may be a flexible printed circuit board, a printed circuit board, or a flexible film such as a chip-on film.

The circuit board 1030 may include conductive layers (not shown) that transmits a signal from a main circuit board (not shown) to the display driver circuit 1020 or electrically connects the touch driver circuit 1040 with the touch electrodes TE of the touch unit TSU.

The touch driver circuit 1040 may be disposed in the subsidiary area SBA of the display panel 1010. As an example, the touch driver circuit 1040 may be mounted on the circuit board 1030.

The touch driver circuit 1040 may be implemented as an integrated circuit (IC) and may be mounted on the display panel 1010 by the chip-on-glass (COG) technique, or the chip-on-plastic (COP) technique.

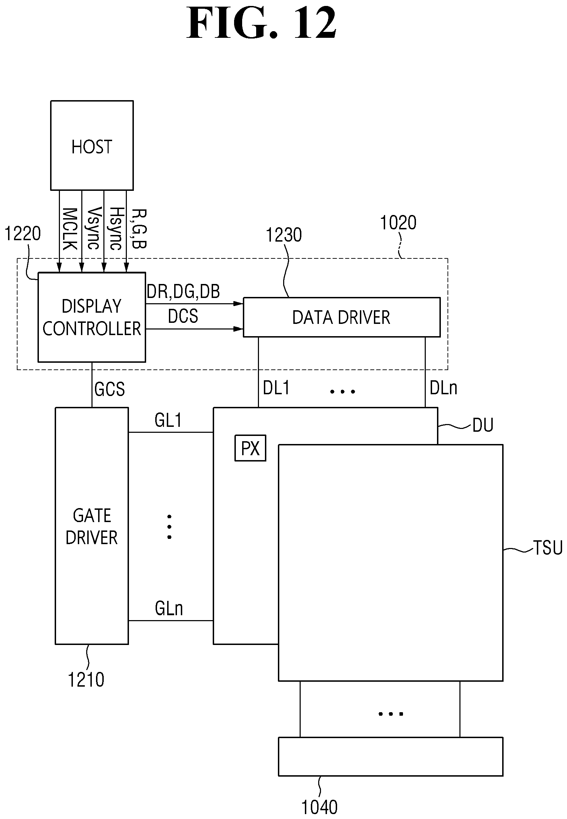

FIG. 12 is a block diagram for illustrating driving a display unit and a touch unit according to an embodiment. For example, FIG. 12 is a block diagram for illustrating driving of the display unit DU and the touch unit TSU shown in FIGS. 10 and 11.

Referring to FIG. 12, a display device 1000 may include a display panel 1010 including pixels PX, a display driver circuit 1020 and a touch driver circuit 1040.

The display driver circuit 1020 may include a data driver 1230 and a display controller (for example, a timing controller) 1220.

The display controller 1220 may receive input data R, G and B and timing control signals from an external source (for example, a host). The timing control signals may include a vertical synchronization signal Vsync indicating one frame period, a horizontal synchronization signal Hsync indicating one horizontal period, and a main clock MCLK repeated at a selectable cycle. The input data R, G and B may be RGB data including red image data, green image data, and blue image data. The display controller 1220 may generate output data signals DR, DG and DB and internal control signals using the input data R, G and B and the timing control signal. The internal control signals include a data control signal DCS and a gate control signal GCS.

The display controller 1220 may control the operation of the data driver 1230 by providing the data control signal DCS to the data driver 1230. The display controller 1220 may control the operation of the gate driver 1210 by providing the gate control signal GCS to the gate driver 1210.

The data driver 1230 may receive the output data signals DR, DG and DB and the data control signal DCS from the display controller 1220. The data driver 1230 may generate a data signal using the output data signals DR, DG and DB and the data control signal DCS. The data driver 1230 may provide the generated data signal to the display panel 1010. The data driver 1230 may provide data signals to the pixels PX through data lines DL1 to DLn formed in the display panel 1010.

The gate driver 1210 may receive the gate control signal GCS from the display controller 1220. The gate driver 1210 may generate a gate signal using the received gate control signal GCS. The gate driver 1210 may provide the generated gate signal to the display panel 1010. The gate driver 1210 may provide gate signals to the pixels PX through gate lines GL1 to GLn formed in the display panel 1010.

Although FIG. 12 illustrates that the display driver circuit 1020 does not include the gate driver 1210, the invention is not limited thereto. For example, the gate driver 1210 may be included in the display driver circuit 1020 that controls the operation of the display panel 1010. The gate driver 1210, the data driver 1230 and the display controller 1220 may be implemented as integrated circuits (ICs). The gate driver 1210 may be formed together during a process of fabricating thin-film transistors of the display panel 1010. The display controller 1220 and the data driver 1230 may be merged to form a timing controller embedded driver (TED) integrated circuit.

The display panel 1010 may include pixels PX connected to data lines DL1 to DLn and gate lines GL1 to GLn.

A frame frequency at which the display driver circuit 1020 drives the display panel 1010 may be variable. For example, the frame frequency may vary within a range of about 1 Hz to about 240 Hz pursuant to a host or a user's selection. The display driver circuit 1020 may drive it at about 60 Hz for one period and may change the frame frequency to about 120 Hz for another period pursuant to a user's needs.

The touch unit TSU may include touch electrodes TE (see FIG. 13) and touch lines SL1 connected to the touch electrodes TE. The touch lines SL1 may be extended to the non-display area NDA and may be connected to the touch connection lines SL2 through the switching circuits M1 and M2.

The display unit DU may include the display area DPA and the non-display area NDA. The display unit DU may include sub-pixels PX, and gate lines GL1 to GLn and data lines DL1 to DLn connected to the sub-pixels PX.

The gate lines GL1 to GLn may supply the gate signals received from the gate driver 1210 to the sub-pixels PX. The gate lines GL1 to GLn may be extended in the first direction X and may be spaced apart from one another in the second direction Y intersecting the first direction X.

The data lines DL1 to DLn may supply the output data signals DR, DG and DB and the data signals received from the display driver circuit 1020 to the sub-pixels PX. The data lines DL1 to DLn may be extended in the second direction Y and may be spaced apart from one another in the first direction X.

The non-display area NDA may surround the display area DPA. For example, the non-display area NDA may include the gate driver 1210 for applying gate signals to the gate lines GL1 to GLn, fan-out lines for connecting the data lines DL1 to DLn with the display driver circuit 1020, and a display pad area (for example, display pads) connected to circuit board 1030. The non-display area NDA may include switching circuits M1 and M2 for switching the connection between the touch lines SL1 and the touch connection lines SL2, and a touch pad area (for example, touch pads) connected to the circuit board 1030.

FIG. 13 is a schematic plan view schematically showing a display panel 100 according to an embodiment. For example, FIG. 13 may be a schematic plan view of the display panel 100 described above with reference to FIGS. 10 and 11.

The embodiment of FIG. 13 may be at least partially similar to the embodiment of FIG. 3. The following description will focus on the differences. The components identical to those described in the embodiment of FIGS. 3 to 9 will not be described again.

The embodiment of FIG. 13 may be different from the embodiment of FIG. 3 in that a display area DPA is not expanded, including the first auxiliary area AA1 and the second auxiliary area AA2. The embodiment of FIG. 13 may be different from the embodiment of FIG. 3 in that switching circuits M1 and M2 are disposed in a subsidiary area SBA. For example, touch lines SL1 connected to touch electrodes TE are extended to the subsidiary area SBA of the display panel 100. The touch lines SL1 extended to the subsidiary area SBA are in contact with input pads of the switching circuits M1 and M2 and thus connected to the switching circuits M1 and M2. The switching circuits M1 and M2 switches the connection between touch lines SL1 and touch connection lines SL2 extending from a touch pad 1310.

The switching thin-film transistors TR of the switching circuits M1 and M2 may include switching thin-film transistors TR1, TR2, TR3 and TR4 (see FIG. 7). The switching thin-film transistors TR1, TR2, TR3 and TR4 (see FIG. 7) may be electrically connected to the touch lines SL1 through the input pads, and may connect them with touch connection lines SL2 connected to the pad area (touch pad area) at the ratio of n : 1, where n is an integer equal to or greater than two. The touch connection lines SL1 may also include touch connection lines SL11, SL12, SL13, and SL14. The switching thin-film transistors TR of the switching circuits M1 and M2 are substantially identical to the switching thin-film transistors TR described above with reference to FIG. 7.

Incidentally, the input pads connecting the touch lines SL1 with the switching thin-film transistors TR of the switching circuits M1 and M2 are disposed in the subsidiary area SBA in the vicinity of the switching circuits M1 and M2. Similar to the input pads described above with reference to FIGS. 4 to 6, such input pads may be arranged in a contact area (for example, the area 403 of FIG. 6). The touch lines SL1 extended to the contact area 403 may cover the pad electrode MPD through the pad contact hole MCT in each of the input pads. Accordingly, the touch lines SL1 may be electrically connected to the pad electrodes MPD. Herein, the pad electrodes MPD may be connected to the switching thin-film transistors TR1, TR2, TR3 and TR4 (see FIG. 7) included in the switching circuits M1 and M2. For example, as indicated by a dashed line 1301 in FIG. 13, the subsidiary area SBA near the switching circuits M1 and M2 may include contact areas 403, and input pads similar to the input pads described above with reference to FIGS. 4 to 6 may be disposed in the contact areas 403.

Although embodiments have been described with reference to the accompanying drawings, those skilled in the art would understand that various modifications and alterations may be made without departing from the technical idea or essential features of the invention. Therefore, it should be understood that the above-mentioned embodiments are not limiting but illustrative in all aspects.

In concluding the detailed description, those skilled in the art will appreciate that many variations and modifications can be made to the embodiments without substantially departing from the principles of the invention. Therefore, the disclosed embodiments are used in a generic and descriptive sense only and not for purposes of limitation.

## Claims

1. A display device (10, 1000) comprising:
a display panel (100, 1010) comprising a display area (DPA) comprising light-emitting elements (LEL) and a non-display area (NDA) comprising display pads and touch pads, the display panel (100, 1010) comprising:
a plurality of touch electrodes (TE) disposed on the light-emitting elements (LEL) in the display area (DPA);
a plurality of touch lines (SL1) electrically connected to the plurality of touch electrodes (TE) and extended to the non-display area (NDA); and
a switching circuit (M1, M2) electrically connected to the plurality of touch lines (SL1) through a plurality of input pads in the non-display area (NDA) and switching a connection between the plurality of touch lines (SL1) and touch connection lines (SL2) electrically connected to the touch pads, wherein
the plurality of input pads are disposed in a contact area (403, 405) of the non-display area (NDA),
**characterized in that**
a plurality of inorganic films are stacked in the contact area (403, 405).

2. The display device (10, 1000) of claim 1, wherein
each of the plurality of input pads comprises:
a pad electrode (MPD) stacked on a layer among the plurality of inorganic films and electrically connected to a thin-film transistor of the switching circuit (M1, M2); and
a pad contact hole (MCT) penetrating at least a part or a number of the plurality of inorganic films to expose an upper surface of the pad electrode (MPD), and
each of the plurality of touch lines (SL1) is extended from the display area (DPA) to the contact area (403, 405) and is electrically connected to the pad electrode (MPD) through the pad contact hole (MCT).

3. The display device (10, 1000) of claim 1 or 2, further comprising in the display area (DPA):
a first thin-film transistor (TFT1) comprising a first gate electrode (G1) and a first inorganic layer (541) disposed on the first gate electrode (G1);
a second thin-film transistor (TFT2) disposed on the first thin-film transistor (TFT1) and comprising a second gate electrode (G2) and a second inorganic film (550) disposed on the second gate electrode (G2);
an OLED disposed on the second thin-film transistor (TFT2) and comprising an emissive layer (572); and
at least one organic film (560, 570, 580) disposed between the second thin-film transistor (TFT2) and the OLED.

4. The display device (10, 1000) of claim 3, wherein
the plurality of touch electrodes (TE) are disposed in a layer on the OLED, and
the plurality of touch lines (SL1) and the plurality of touch electrodes (TE) are disposed in a same layer.

5. The display device (10, 1000) of claim 2 and of claim 3 or 4, wherein the pad electrode (MPD) and the second gate electrode (G2) of the second thin-film transistor (TFT2) are disposed in a same layer.

6. The display device (10, 1000) of claim 5, wherein the pad contact hole (MCT) penetrates the second inorganic film (550) to expose the upper surface of the pad electrode (MPD).

7. The display device (10, 1000) of at least one of claims 1 to 6, wherein the switching circuit (M1, M2) comprises a plurality of switching thin-film transistors (TR) that switch connections between the plurality of touch lines (SL1) and the touch connection lines (SL2) at a ratio of n : 1 where n is an integer equal to or greater than two.

8. The display device (10, 1000) of at least one of claims 3 to 7, wherein the plurality of switching thin-film transistors (TR) and one of the first thin-film transistor (TFT1) and the second thin-film transistor (TFT2) are disposed in a same layer.

9. The display device (10, 1000) of claim 8, wherein a passivation film and the at least one organic film (560, 570, 580) disposed between the second thin-film transistor (TFT2) and the OLED in a same layer are disposed on one of a switching thin-film transistor (TR) of the plurality of switching thin-film transistors (TR).

10. The display device (10, 1000) of at least one of claims 3 to 9, wherein
a capacitor electrode (CAE1) disposed on a layer between the first thin-film transistor (TFT1) and the second thin-film transistor (TFT2) is disposed in the display area (DPA), and
the capacitor electrode (CAE1), the first gate electrode (G1), and the second gate electrode (G2) are formed of a same material.

11. The display device (10, 1000) according to at least one of claims 1 to 10, wherein
the contact area (403, 405) is disposed between a border of the non-display area (NDA) disposed on an outer side of the switching circuit (M1, M2).

12. The display device (10, 1000) of claim 11, wherein
each of the plurality of touch lines (SL1) is extended from the display area (DPA) to the contact area (403, 405) via the switching circuit (M1, M2) and is electrically connected to the pad electrode (MPD) through the pad contact hole (MCT).
